# EUROPEAN PATENT SPECIFICATION

(11) **EP 4 386 818 B1**
(45) Date of publication and mention of the grant of the patent: **06.05.2026**
(21) Application number: 21953371.8
(22) Date of filing: 22.11.2021
(51) Int. Cl.: G01N 1/02

(54) **EDGE SCANNING APPARATUS AND METAL CONTAMINATION MEASUREMENT DEVICE**
KANTENABTASTVORRICHTUNG UND METALLKONTAMINATIONSMESSVORRICHTUNG
APPAREIL DE BALAYAGE DE BORD ET DISPOSITIF DE MESURE DE CONTAMINATION MÉTALLIQUE

(30) Priority: 10.08.2021 CN 202110914183
(43) Date of publication of application: 19.06.2024
(73) Proprietor: Jiangsu Leuven Instruments Co. Ltd, Xuzhou, Jiangsu 221300 (CN)
(72) Inventor: YU, Xiang, Xuzhou, Jiangsu 221300 (CN); CHENG, Shiran, Xuzhou, Jiangsu 221300 (CN); ZHANG, Huaidong, Xuzhou, Jiangsu 221300 (CN); YANG, Chaoquan, Xuzhou, Jiangsu 221300 (CN); CUI, Hushan, Xuzhou, Jiangsu 221300 (CN); LIU, Pengfei, Xuzhou, Jiangsu 221300 (CN); HU, Dongdong, Xuzhou, Jiangsu 221300 (CN); XU, Kaidong, Xuzhou, Jiangsu 221300 (CN)
(74) Representative: Eisenführ Speiser
(86) International application number: PCT/CN2021/132025
(87) International publication number: WO 2023/015766

(56) References cited:
- WO-A1-2017/217804
- CN-A- 102 194 726
- CN-A- 107 567 652
- JP-A- 2005 109 292
- JP-A- 2005 109 292
- JP-A- 2010 060 439
- JP-A- 2015 099 103
- JP-A- 2015 099 103
- JP-A- 2017 083 334
- JP-A- 2017 083 334
- US-A1- 2002 134 406
- US-A1- 2007 204 881
- US-A1- 2019 172 729
- US-A1- 2020 234 985
- US-B1- 9 196 471

## Description

This application claims priority to Chinese Patent Application No. 202110914183.8, titled "APPARATUS FOR EDGE SCANNING AND DEVICE FOR DETECTING METALLIC COMTAMINANTS", filed on August 10, 2021 with the China National Intellectual Property Administration.

### FIELD

The present disclosure relates to the technical field of sample scanning, and in particular to an apparatus for edge scanning and a device for detecting metallic contaminants.

### BACKGROUND

In order to analyze an end region of a wafer, in a method and a device for analyzing impurities of the wafer, it is proposed in JP2010 060439 A that the method of analyzing the impurities of the wafer comprises a step of preparing a liquid drop between a lower drop cage and an upper drop cage so that the lower surface of the drop comes into contact with the lower drop cage and the top surface of the drop comes into contact with the upper drop cage, a step of scanning the wafer with the drop while the wafer is brought into contact with one surface of the drop and a step of sucking and analyzing the drop.

A horizontal scanner, a vertical scanner, and a dual-configuration scanner that is able to convert between a horizontal scanner and a vertical scanner are described in US9196471 B1.

JP 2005 109292 A aims at providing a collection method and device, having simple constitution and being capable of easily and stably collecting the substances to be measured from a wafer peripheral part. Since substances to be measured, which exist in a wafer peripheral part, are collected by bringing the wafer peripheral part into contact with a droplet on a collecting solution holding board, a wafer is set laterally; and the wafer peripheral part is brought into contact with the droplet on the collecting solution holding board differently from a conventional method, in which the wafer is set vertically, and the wafer peripheral part is dipped into chemicals in a dipping container. Consequently problems, such as pollution of chemicals and complexity of handling can be solved, the structure can be simplified and substances to be measured can be collected easily and stably from the wafer peripheral part.

In order to provide a substrate inspection device and a recovery tool suitable for sticking a droplet to an edge of a substrate and moving it along the edge, it is proposed in JP 2015 099103 A that the substrate inspection device includes a substrate rotary apparatus, a recovery tool, and a recovery tool holding apparatus. The recovery tool includes: gas supplying means for supplying gas; a first tool for holding a droplet adhering to an edge of a substrate; and a second tool for guiding gas along the border of an adhesion region, as the region in which the droplet held by the first tool adheres to the edge of the substrate, so as to spray the gas to the surface of the substrate.

Various new chemical elements are inevitably introduced when manufacturing chips with high performances and low power consumption, and such introduction renders metallic contamination difficult to control in the manufacture. At present, a system for collecting metallic contaminants using vapor phase decomposition and an inductively coupled plasma mass spectrometer form the most common devices for detecting metallic contaminants. These devices conduct detection mainly on central regions of to-be-detected wafers.

### SUMMARY

An objective of the present disclosure is providing an apparatus for edge scanning and a device for detecting metallic contaminants. The apparatus is capable to perform scanning and sampling on an edge of a sample, and thereby provide a basis for conducting detection on the edge of the sample.

In order to address at least the above issues, an apparatus for scanning an edge is provided as defined in claim 1.

During operation, the sample may be disposed on the carrying portion, and then the scanning-liquid supplying-drawing component may dribble the droplet of the scanning fluid via the nozzle. An upper part of the droplet still suspends on the nozzle, that is, the droplet has not been separated from the nozzle, while a lower part of the droplet is supported by the supporting arm, thereby avoiding the droplet from dropping. At the same time, the droplet may wrap the edge of the sample. Afterwards, the rotating component may be activated to drive the sample to rotate for at least one revolution, so that the droplet is capable to perform sampling on every position along the edge of the sample. Then, the scanning-liquid supplying-drawing component may draw the droplet via the nozzle. Thereby, scanning and sampling on the edge of the sample is completed, thereby providing a basis for conducting detection on the edge of the sample.

In other words, the apparatus for edge scanning provided herein is capable to fill the blank in conventional technology by facilitating sampling and detection on the edge of the sample. Thereby, the sampling and detection on the sample is more thorough and thus perfected.

In one embodiment, the apparatus further comprises a cleaning component, configured to clean the supporting arm.

In one embodiment, the supporting arm has a supporting position and a cleaning position, and a driving mechanism of the supporting component is configured to drive the supporting arm switch between the supporting position and the cleaning position.

In one embodiment, the cleaning component comprises a shell enclosing a cleaning chamber, where: a wall of the shell is provided with a first entrance opening into the cleaning chamber, and the supporting arm is capable to enter and exit the cleaning chamber through the first entrance; a cleaning member of the cleaning component is capable to clean the supporting arm in the cleaning chamber.

In one embodiment, the cleaning member comprises one or both of a liquid rinsing component and a gas purging component, where a lower part of the shell is provided with a first drain port connecting the cleaning chamber.

In one embodiment, a height-adjusting member for the supporting component is configured to adjust a height of the supporting arm when mounting the supporting arm.

In one embodiment, the carrying portion is a suction cup for providing negative pressure.

In one embodiment, the apparatus comprises a cleaning component configured to cleaning the supporting arm, where: the cleaning component is installed on the platform plate, and the third annular groove surrounds the cleaning component.

In one embodiment, one or both of: at least a portion located above the upper surface of the platform plate, in each of the rotating component, the scanning-liquid supplying-drawing component, the supporting component, and the cleaning component, and the platform plate, is either made of a corrosion-resistant material or coated with a corrosion-resistant layer.

In one embodiment, the apparatus further comprises a cover, configured to be mounted on the platform plate and enclose an accommodation chamber along with the platform plate, where the cover is provided with a second entrance, and the sample is capable to enter and exit the accommodation chamber through the second entrance.

In one embodiment, the supporting arm is made of an antistatic material, or coated with an antistatic layer.

A device for detecting metallic contaminants is further provided according to embodiments of the present disclosure. The device comprises any foregoing apparatus.

As the foregoing apparatuses have the aforementioned technical effects, the device comprising the apparatus also has similar technical effects, which are not repeated herein.

### BRIEF DESCRIPTION OF THE DRAWINGS

Figure 1 is a schematic structural diagram of an edge scanning apparatus which is scanning an outer edge of a to-be-tested sample according to an embodiment of the present disclosure.
Figure 2 is a top view of a structure as shown in Figure 1 according to an embodiment of the present disclosure.
Figure 3 is another view of a structure as shown in Figure 1 according to an embodiment of the present disclosure.
Figure 4 is a schematic structural diagram of an edge scanning apparatus which is cleaning a supporting arm according to an embodiment of the present disclosure.
Figure 5 is a schematic structural diagram of a supporting component according to an embodiment of the present disclosure.
Figure 6 is a schematic structural diagram of a cleaning component according to an embodiment of the present disclosure.
Figure 7 is a cross-sectional view of a structure as shown in Figure 6 according to an embodiment of the present disclosure.
Figure 8 is a schematic structural diagram of a platform plate according to an embodiment of the present disclosure.
Figure 9 is a cross-sectional view of a structure as show in Figure 8 according to an embodiment of the present disclosure.

Reference numerals:

| | | | |
|---|---|---|---|
| 1: | rotating component; | 11: | carrying portion; |
| 2: | nozzle; | 3: | supporting component; |
| 31: | supporting arm; | 311: | concave part; |
| 32: | relay arm; | 33: | rotating shaft; |
| 34: | adjusting screw; | 35: | fixing plate; |
| 351: | fixing screw; | 352: | positioning pin; |
| 353: | bearing; | 36: | motor bracket; |
| 37: | motor; | 38: | shaft coupler; |
| 39: | shaft key; | 4: | cleaning component; |
| 41: | shell; | 411: | upper shell; |
| 412: | lower shell; | 413: | cleaning chamber; |
| 414: | first entrance; | 415: | first drain port; |
| 42: | first drain connector; | 43: | liquid supply connector; |
| 44: | gas supply connector; | 5: | platform plate; |
| 51: | first annular groove; | 52: | second drain port; |
| 53: | second drain connector; | 54: | second annular groove; |
| 55: | first connection groove; | 56: | third annular groove; |
| 57: | second connection groove; | 5a: | mounting region; |
| 5b: | inclined portion; | 6: | cover; |
| 61: | second entrance; | 62: | third entrance; |
| 63: | accommodation chamber; | 7: | ventilation part; |
| A: | to-be-tested sample. | | |

### DETAILED DESCRIPTION OF EMBODIMENTS

Hereinafter the present disclosure is further described in detail in conjunction with the drawings and specific embodiments, so as to enable those skilled in the art to better understand technical solutions of the present disclosure.

Herein the terms "first", "second", and the like are only intended for facilitating describing two or more structures or components having identical or similar structures and/or function, and do not indicate any special limitation with respect to an order and/or importance.

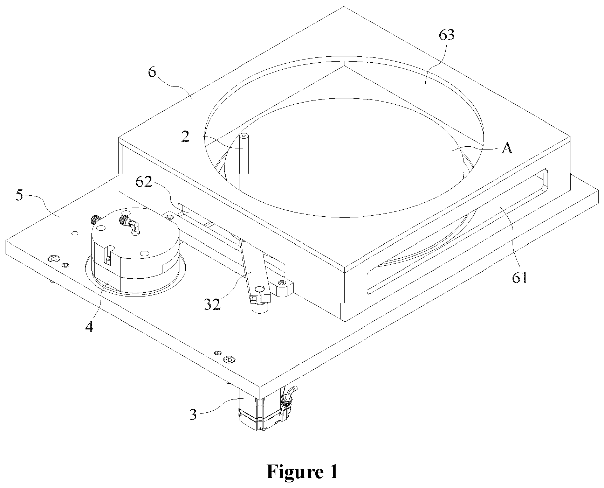

Herein the terms indicating orientation or a positional relationship, such as "upper" and "lower", are based on a range and a positional relationship during actual usage of a device, or may refer to the orientation and the positional relationship as shown in Figure 1.

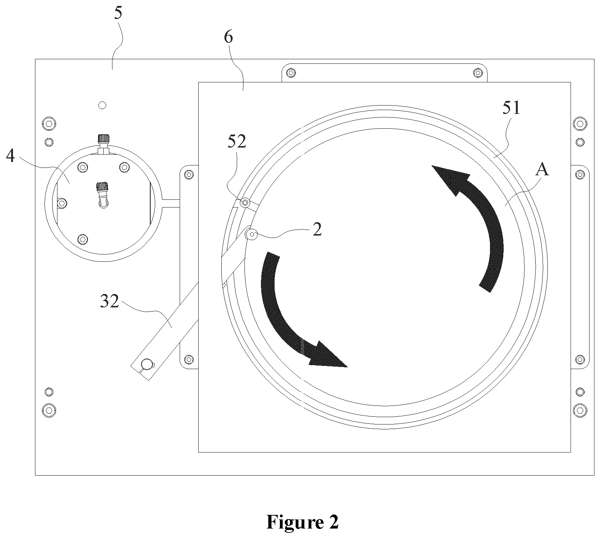

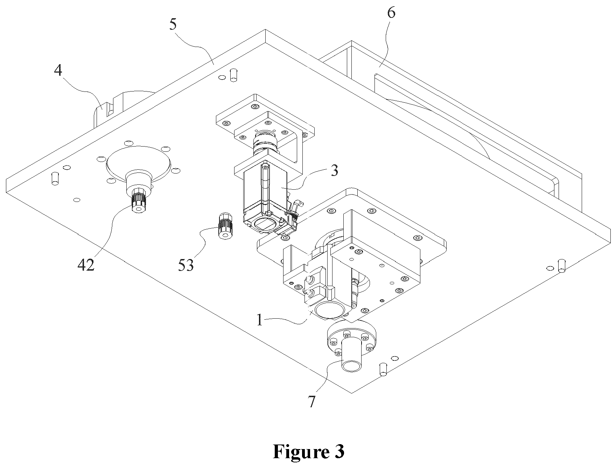

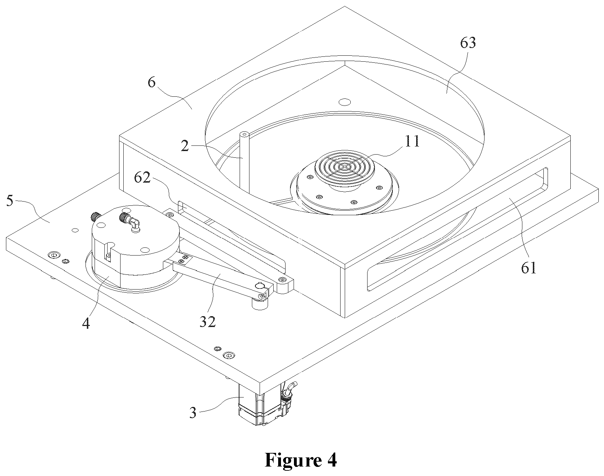

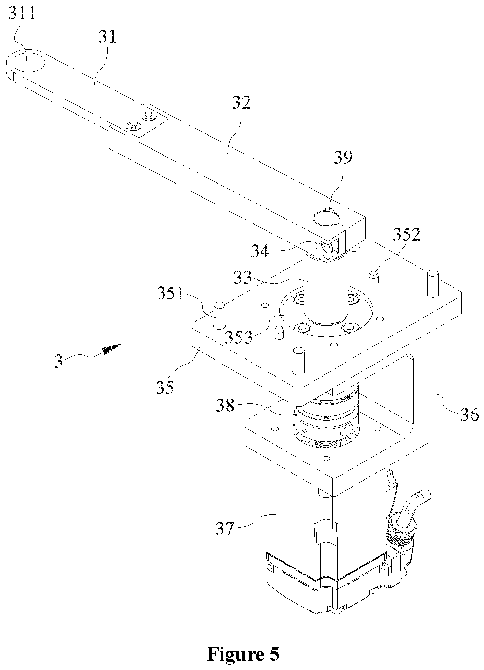

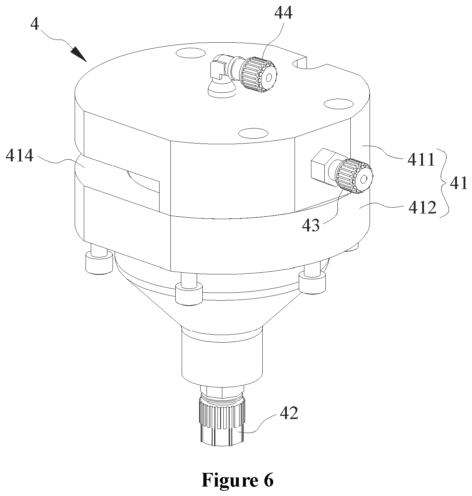

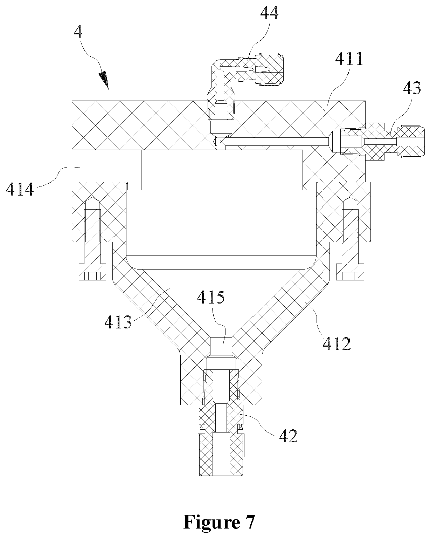

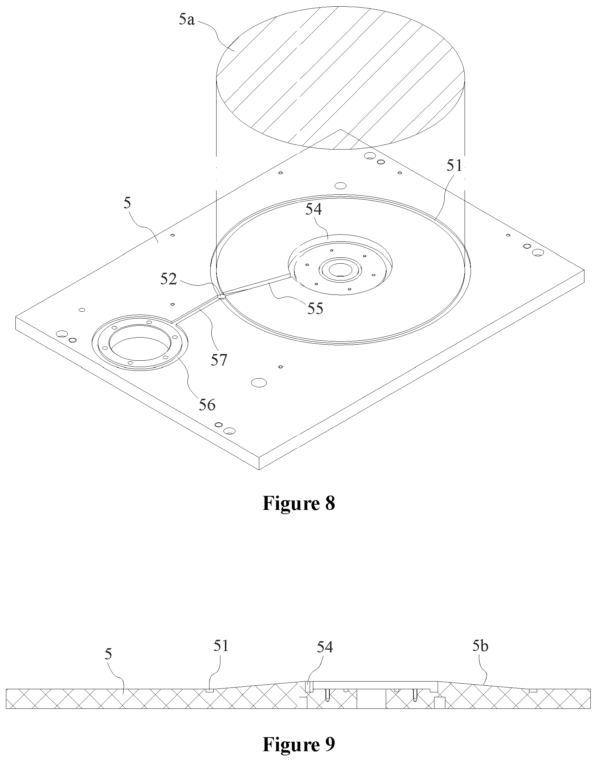

Reference is made to to Figures 1 to 9. Figure 1 shows a schematic structural diagram of an edge scanning apparatus which is scanning an outer edge of a to-be-tested sample according to an embodiment of the present disclosure. Figure 2 shows a top view of a structure as shown in Figure 1. Figure 3 shows another view of a structure as shown in Figure 1. Figure 4 is a schematic structural diagram of an edge scanning apparatus which is cleaning a supporting arm according to an embodiment of the present disclosure. Figure 5 is a schematic structural diagram of a supporting component. Figure 6 is a schematic structural diagram of a cleaning component. Figure 7 is a cross-sectional view of a structure as shown in Figure 6. Figure 8 is a schematic structural diagram of a platform plate. Figure 9 is a cross-sectional view of a structure as show in Figure 8.

As mentioned in the background, conventional device for detecting metallic contaminants performs sampling and detection mainly on central regions of to-be-tested wafers, and neglects sampling and detecting on an edge region of the to-be-tested wafer, which results in a flaw of detecting metallic contaminants.

An apparatus for scanning an edge is provided according to embodiments of the present disclosure. As shown in Figures 1 to 4, the apparatus comprises a rotating component 1, a scanning-liquid supplying-drawing component, and a supporting component 3. The rotating component 1 comprises a carrying portion 11 configured to carry the to-be-tested sample A, which may be a wafer or another similar to-be-tested piece. The rotating component 1 is capable to drive the sample A to rotate. The scanning-liquid supplying-drawing component comprises a nozzle 2 configured to dribble and draw a droplet of a scanning fluid. The supporting component 3 comprises a supporting arm 31. The droplet is capable to be accommodated between the nozzle 2 and the supporting arm 31 while wrapping an edge of the sample A.

During operation, the sample A may be disposed on the carrying portion 11, and then the scanning-liquid supplying-drawing component may dribble the droplet of the scanning fluid via the nozzle 2. An upper part of the droplet still suspends on the nozzle 2, that is, the droplet has not been separated from the nozzle 2, while a lower part of the droplet is supported by the supporting arm 31, thereby avoiding the droplet from dropping. At the same time, the droplet may wrap the edge of the sample A. Afterwards, the rotating component 1 may be activated to drive the sample A to rotate for at least one revolution, so that the droplet is capable to perform sampling on every position along the edge of the sample A. Then, the scanning-liquid supplying-drawing component may draw the droplet via the nozzle 2. Thereby, scanning and sampling on the edge of the sample A is completed, thereby providing a basis for conducting detection on the edge of the sample A.

In other words, the apparatus for edge scanning provided herein is capable to fill the blank in conventional technology by facilitating sampling and detection on the edge of the sample A. Thereby, the sampling and detection on the sample A is more thorough and thus perfected.

Although the apparatus provided here is basically designed for detecting metallic contaminants, it is appreciated that application of the apparatus is not limited to such function. As a matter of fact, the apparatus may be applied to detecting impurities of other types, such as dusts and the like. That is, application scenarios shall not be construed as a limitation of implementations of the apparatus provided herein. Different application scenarios may require different types of the scanning fluid, which are not limited herein.

The carrying portion 11 is mainly configured to carry the sample A. A structure of the carrying portion 11 may be implemented in various forms, as long as a function of carrying can be achieved. In an embodiment, the carrying portion 11 may be a suction cup providing negative pressure, and hence is capable to suck the sample A under the negative pressure. Thereby, the sample A can be carried and fixed more stably. A specific design of a pipeline providing the negative pressure is not limited herein, as long as the negative pressure can lead to suction.

The rotating component 1 further has a rotation driving mechanism. Herein the rotation driving mechanism for the rotating component 1 is denoted as the first rotation driving mechanism, in order to distinguish from another rotation driving mechanism for the supporting component 3 which would be described later. The first rotation driving mechanism is mainly configured to drive rotation of the carrying portion 11, and thereby drive rotation of the sample A located on the carrying portion 11. A specific structure of the first rotation driving mechanism is not limited herein, as long as it can achieve a function of driving, or may refer to relevant description of a structure of the second rotation driving mechanism in following description.

The apparatus may further comprise a cleaning component 4 configured to clean the supporting arm 31. Thereby, the supporting arm 31 may be cleaned by the cleaning component 4 each time a scan on the edge is completed and the droplet is drawn, so as to avoid cross-contamination. It also facilitates ensuring accuracy of results of subsequent detection.

The supporting arm 31 may be disposed at the same position during supporting the droplet and during subsequent cleaning. Alternatively, the supporting arm 31 may be disposed at different positions during supporting the droplet and during subsequent cleaning. In order to facilitate description, a position at which the supporting arm 31 is disposed when supporting the droplet is called a supporting position, and a position at which the supporting arm 31 is capable of being cleaned by the cleaning component 4 is called a cleaning position. In the latter case, the cleaning component 4 may be installed at a position distant from the nozzle 2 and the sample A, and hence the various components would not interfere or influence each other during installation and usage.

Herein the latter case may be preferable, and there may be a driving mechanism configured to drive the supporting arm 31 to switch between the supporting position and the cleaning position. The movement induced by the driving mechanism may be translation or rotation, as long as switching between the positions can be achieve. Different forms of the moment may correspond to different structures of the driving mechanism.

As an example, the movement is translation, and the driving mechanism may be a component capable to drive the translation directly, such as an air cylinder or a hydraulic cylinder. Alternatively, the driving mechanism may be a motor in combination with a transmission component for converting rotation into the translation, such as a structure of gear rack and pinion and a structure of screw. As another example, the movement is rotation, and the driving mechanism may be a component capable to drive the rotation directly, such as a motor. Other components such as a reducer may be further provided when necessary.

Reference is made to Figure 5. The driving mechanism may be a rotation driving mechanism. The rotation driving mechanism for the supporting component 3 is called a second rotation driving mechanism for the aforementioned distinction. The second rotation driving mechanism may comprise a motor 37, and a rotating shaft of the motor 37 may be connected to a rotating shaft 33 through a shaft coupler 38. The motor 37 may be mounted on a fixing plate 35 through a motor bracket 36, and the fixing plate 35 may be fixedly mounted through a connector, such as fixing screws 351. The fixing plate 35 may further have a positioning component, such as a positioning pin 352, configured to determine a mounting position of the second rotation driving mechanism. In practice, the positioning pin 352 is first used for positioning, such that the fixing screw 351 can be conveniently installed. The fixing plate 35 may further have a bearing 353 for relative rotation between the rotating shaft 33 and the fixing plate 35. The rotating shaft 33 may be directly connected to the supporting arm 31. Alternative, there is a relay arm 32, via which the rotating shaft 33 is connected to the supporting arm 31. The relay arm 32 and the supporting arm 31 may be connected through a connection component such as screws. The relay arm 32 and the rotating shaft 33 may be connected via shaft key 39, which ensures that the relay arm 32 and the rotating shaft 33 rotate synchronously. The supporting arm 31 is configured to contact the droplet directly, and hence there may be a high requirement on a material of the supporting arm 31. In one embodiment, the supporting arm 31 is made of an antistatic material, such as polyether ether ketone (PEEK), or at least is coated with an antistatic layer. The supporting arm 31 and the relay arm 32 are different sections, and only a material of the supporting arm 31 is subject to a requirement. Thereby, costs are effectively controlled, selection among supporting arms 31 of different materials is convenient for different application scenarios while meeting a requirement on a mounting position of the supporting arm 31.

The foregoing description of a structure of the second rotation driving mechanism is only illustrative and shall not be construed as a limitation on an application scope of the apparatus provided herein. The second rotation driving mechanism may adopt another structure as along as a requirement on its function is met. For example, as shown in Figure 5, the motor 37 further have a reducer, and is connected to the rotating shaft 33 via an output shaft of the reducer. It is appreciated that the rotating shaft of the motor 37 or the output shaft of the reducer may serve as the rotating shaft 33 directly. The motor bracket 36 and the fixing plate 35 may be integral, that is, the two may be integrated as one component, so as to reduce a quantity of the components.

In the supporting arm 31, a portion for supporting the droplet may be a flat part, or as shown in Figure 5, a concave part 311. The concave part 311 has a better supporting capability in preventing the droplet from falling, and hence may be preferable.

Furthermore, the supporting component 3 may have a height-adjusting member configured to adjusting a height of the supporting arm 31 when installing the supporting arm. Thereby, the supporting arm 31 and the nozzle 2 is capable to coordinate better for holding the droplet being suspended on the nozzle, when the supporting arm 31 is located at the supporting position.

There are various choices for a structure of the height-adjusting member, for example, an adjustment screw. Reference is made to Figure 5. An end of the relay arm 32, which connects the rotating shaft 33, may comprise two abutting parts facing each other. A distance between the two abutting parts can be adjusted through the adjusting screw 34, so that they can clamp the rotating shaft 33 tightly or release the rotating shaft 33. When the two abutting parts do not clamp the rotating shaft 33 tightly, the relay arm 32 is capable to move with respect to an axial direction of the rotating shaft 33, such that it is convenient to adjust an installation position of the relay arm 32 on the rotating shaft 33, and hence alter the installation height of the supporting arm 31. After the installation height of the supporting arm 31 is determined, the adjusting screw 34 may be tightened to fix the supporting arm 31 to the current installation height.

Reference is made to Figures 4, 6 and 7. The cleaning component 4 may comprise a shell 41 which may enclose a cleaning chamber 413. A wall of the shell 41 may be provided with a first entrance 414 opening into the cleaning chamber 413, such that the supporting arm 31 is capable to enter and exit the cleaning chamber 413 through the first entrance 414 (where a manner of entering and exiting may be rotation or translation). The cleaning component 4 may further have a cleaning member configured to clean the supporting arm 31 in the cleaning chamber 413. In such solution, the cleaning component 4 is capable to achieve cleaning of the supporting arm 31 in the cleaning chamber 413, and a medium for cleaning can be easily recycled and less likely to pollute an ambient environment.

The cleaning component may comprise a liquid rinsing component, which comprises a liquid supply connector 43. The cleaning liquid may enter the cleaning chamber 413 through the liquid supply connector 43. A type of the cleaning liquid is not limited herein. In an embodiment, the cleaning liquid is preferably water, so as to avoid introducing other chemicals and affecting accuracy of scanning and sampling on the edge of the sample A through the droplet. A lower part of the shell 41 may be provided with a first drain port 415 connected to the cleaning chamber 413. The first drain port 415 is connected to a first drain connector 42 configured to drain a waste liquid from the cleaning chamber 413.

Alternatively or additionally, the cleaning component may comprise a gas purging component, which comprises a gas supply connector 44 through which a gas is capable to enter the cleaning chamber 413. The gas may serve directly as a cleaning gas for cleaning the supporting arm 31 through gas purging, or may serves merely as a drying gas. In the latter case, the gas purging component needs to coordinate with the liquid rinsing component. The gas purging component may dry the supporting arm 31 after the liquid rinsing component rinses the supporting arm 31. Thereby, the cleaning liquid is not apt to sputter after the supporting arm 31 exits the cleaning chamber 413, which ensures a clean environment around the cleaning component 4. A type of the gas is not limited herein. In practice, those skilled in the art may select the gas according to a requirement. In one embodiment, an inert gas, nitrogen, or the like may be utilized. The inert gas is stable, and hence is not apt to contaminate the supporting arm 31 and affect subsequent operation of the supporting arm 31.

Detailed illustration may refer to Figure 7. The shell 41 may comprise an upper shell 411 and a lower shell 412. The first entrance 414 may be formed at a joint of the upper shell 411 and the lower shell 412. In an embodiment, the first entrance 414 may be formed as an opening in the upper shell 411 and/or the lower shell 412. A manner of connecting the upper shell 411 and the lower shell 412 is not limited herein. The liquid supply connector 43 and the gas supply connector 44 each may be disposed at the upper shell 411, and a corresponding pipeline for supplying a liquid or a gas may be disposed in the upper shell 411. A specific structure and a location of the pipeline are not limited herein. The lower shell 412 may be accommodate a main part of the cleaning chamber, and at least a lower portion of its inner wall may be tapered as an inverse cone to facilitate collecting and draining the waste liquid via the first drain port 415. That is, the first drain port 415 may be formed at the lower shell 412, and the first drain connector 42 may be disposed at the lower shell 412.

Specific structures of the liquid supply connector 43, the gas supply connector 44, and the first drain connector 42 are not described herein. In practice, those skilled in the art may configure these structures on requirement. As shown in the drawings, the above three components are adapters for connecting the shell 41 with an external liquid source, an external gas source, and an external waste-liquid recycling component, respectively.

Reference is further made to Figures 1 and 2. The apparatus further comprises a platform plate 5. The rotating component 1, the supporting component 3, and the cleaning component 4 each may be mounted on the platform plate 5. A manner of mounting may be implemented through a connecting member such as screws. Reference is further made to Figures 8 and Figure 9. An upper surface of the platform plate 5 is provided with a first annular groove 51, which encloses a mounting region 5a (where the mounting region 5a is projected upward in Figure 8 to facilitate denotation, and is actually a part of the upper surface of the platform plate 5) of the upper surface of the platform plate 5. An orthographic projection of the sample A on the upper surface of the platform plate 5 is located within the mounting region 5a. The platform plate 5 is further provided with a second drain port 52 opening into the first annular groove 51. The second drain port 52 may be connected to a second drain connector 53, which is configured to drain a waste liquid collected in the first annular groove 51. A quantity and a location of the second drain port(s) 52 are not limited herein.

In the above structure, the orthographic projection of the sample A on the upper surface of the platform plate 5 is located within the mounting region 5a. That is, the first annular groove 51 surrounds the sample A, and the first annular groove 51 is located at a periphery of the sample A. Hence, when a part of the droplet drips or sputters during the scanning, it can be collected by the first annular groove 51 and then drained from the second drain port 52 and the second drain connector 53, which prevents liquid accumulation.

The upper surface of the platform plate 5 is further provided with a second annular groove 54. The second annular groove 54 is located within the mounting region 5a and surround the rotating component 1. That is, a radius of the second annular groove 54 is smaller than that of the first annular groove 51. A first connection groove 55 connects the second annular groove 54 and the first annular groove 51. The second annular groove 54 may serve as a liquid isolation groove, which confines the waste liquid from the platform plate 5 to a region outside the second annular groove 54 and hence avoids the waste liquid from influencing the rotating component 1. The waste liquid accumulated in the second annular groove 54 may flow into the first annular groove 51 via the first connection groove 55 to be drained. The first annular groove 51 and the second annular groove 54 sharing the drain port can reduce a quantity of drain ports and thereby simplify a structure of the platform plate 5.

Alternatively, the second annular groove 54 may have a separate drain port. In such case, the waste liquid accumulated in the second annular groove 54 may be drained through the drain port of the second annular groove 54.

Reference is made to Figure 9. A part of the upper surface of the platform plate 5, which is between the second annular groove 54 and the first annular groove 51, is an inclined portion 5b which slopes downward in a direction pointing from the second annular groove 54 to the first annular groove 51. In such configuration, the waste liquid from the mounting region 5a converge into the first annular groove 51 more easily, such that an issue of liquid accumulation on the platform plate 5 can be better addressed.

Reference is further made to Figure 8. The upper surface of the platform plate 5 is further provided with a third annular groove 56. The third annular groove 56 surrounds the cleaning component 4, and is connected to the first annular groove 51 via a second connection groove 57. The third annular groove 56 may serve as a liquid isolation groove, which confines the waste liquid from the platform plate 5 to a region outside the third annular groove 56 and hence prevents the waste liquid from influencing the cleaning component 4. The waste liquid in the third annular groove 56 may flow into the first annular groove 51 via the second connection groove 57 to be drained. The first annular groove 51 and the third annular groove 56 sharing the drain port can reduce a quantity of drain ports and thereby simplify a structure of the platform plate 5.

Alternatively, the third annular groove 56 may have a separate drain port. In such case, the waste liquid accumulated in the third annular groove 56 may be drain through the drain port of the second annular groove 54.

Furthermore, the apparatus may further comprise a cover 6. The cover 6 may be mounted on the platform plate 5 and may enclose an accommodation chamber 63 along with the platform plate 5. The cover 6 may be provided with a second entrance 61, through which the sample A is capable to enter and exit the accommodation chamber 63. A manner of entering and exiting may be a robotic arm. As shown in Figure 1, in a case that the supporting arm 31 is capable of moving, the cover 6 may be further provided with a third entrance 62 through which the supporting arm 31 is capable to enter and exit the accommodation chamber 63.

The apparatus may further comprise a ventilation component for ventilating the accommodation chamber 63, so as to ensure a clean inner environment of the accommodation chamber 63. The ventilation component may comprise a gas supply part and a ventilation part 7. The gas supply part is configured to provide a highly pure gas, and the ventilation part 7 is configured to draw the gas, so to ensure constant refreshing of the gas in the accommodation chamber 63. Thereby, the gas in the accommodation chamber 63 can be kept clean.

The droplet of the scanning fluid utilized by the apparatus may be corrosive to a certain extent. Therefore, a requirement may be disposed on materials of the components in the apparatus, in order to extend a service life as much as possible.

Each component in the apparatus may be made of a corrosion-resistant material, or at least its outer surface is coated with a corrosion-resistant layer, so as to enhance resistance of each component against a corrosive liquid such as an acid and an alkali. Alternatively, at least a part of each component located above the upper surface of the platform plate 5 is made of the corrosion-resistant material or coated with the corrosion-resistant layer. In an embodiment, the cover 6 may be made of a corrosion-resistant material or coated with a corrosion-resistant layer. At least a part of each of the rotating component 1, the scanning-liquid supplying-drawing component, the supporting component 3, and the cleaning component 4, located above the upper surface of the platform plate 5 is made of a corrosion-resistant material, or coated with a corrosion-resistant layer. A material of the platform plate 5 may be a corrosion-resistant material, or at least the upper surface of the platform plate 5 is coated with a corrosion-resistant layer.

Specific types of the corrosion-resistant material and the corrosion-resistant layer are not limited herein. In practice, those skilled in the art may determine the type of the corrosion-resistant material or the corrosion-resistant layer based on a type of a corrosive substance utilized in a specific application scenario.

A device for detecting metallic contaminants is further provided according to embodiments of the present disclosure. The device comprises the apparatus according to any foregoing embodiment.

As the foregoing apparatuses have the aforementioned technical effects, the device comprising the apparatus also has similar technical effects, which are not repeated herein.

## Claims

1. An apparatus for scanning an edge, comprising:
a rotating component (1), wherein the rotating component (1) comprises a carrying portion (11) configured to carry a sample (A) which is to be tested, wherein the rotating component (1) is configured to drive the sample (A) to rotate;
a scanning-liquid supplying-drawing component, which comprises a nozzle (2) configured to dribble and draw a droplet of a scanning fluid; and
a supporting component (3), comprising a supporting arm (31), wherein the droplet is capable to be accommodated between the nozzle (2) and the supporting arm (31) while wrapping the edge of the sample (A),
the apparatus further comprising a platform plate (5), wherein the rotating component (1) and the supporting component (3) are both mounted on the platform plate (5),
the apparatus being **characterized in that**,
an upper surface of the platform plate (5) is provided with a first annular groove (51) enclosing a mounting region (5a) on the upper surface of the platform plate (5);
an orthographic projection of the sample (A) on the upper surface of the platform plate (5) is located in the mounting region (5a);
a second drain port (52) for the platform plate (5) connects the first annular groove (51);
the upper surface of the platform plate (5) is further provided with a second annular groove (54) located in the mounting region (5a);
the second annular groove (54) surrounds the rotating component (1); and
a first connection groove (55) connects the second annular groove (54) and the first annular groove (51);
a part of the upper surface of the platform plate (5), which is between the second annular groove (54) and the first annular groove (51), slopes downward in a direction pointing from the second annular groove (54) to the first annular groove (51);
the upper surface of the platform plate (5) is provided with a third annular groove (56); and
a second connection groove (57) connects the third annular groove (56) and the first annular groove (51).

2. The apparatus according to claim 1, further comprising a cleaning component (4) configured to clean the supporting arm (31).

3. The apparatus according to claim 2, wherein:
the supporting arm (31) has a supporting position and a cleaning position, and
a driving mechanism of the supporting component (3) is configured to drive the supporting arm (31) to switch between the supporting position and the cleaning position.

4. The apparatus according to claim 3, wherein:
the cleaning component (4) comprises a shell (41) enclosing a cleaning chamber (413), wherein a wall of the shell (41) is provided with a first entrance (414) opening into the cleaning chamber (413), and the supporting arm (31) is capable to enter and exit the cleaning chamber (413) through the first entrance (414); and
a cleaning member of the cleaning component (4) is capable to clean the supporting arm (31) in the cleaning chamber (413).

5. The apparatus according to claim 4, wherein:
the cleaning member comprises one or both of a liquid rinsing component and a gas purging component, and
a lower part of the shell (41) is provided with a first drain port (415) connecting the cleaning chamber (413).

6. The apparatus according to claim 1, wherein a height-adjusting member for the supporting component (3) is configured to adjust a height of the supporting arm (31) when mounting the supporting arm (31).

7. The apparatus according to claim 1, wherein the carrying portion (11) is a suction cup for providing negative pressure.

8. The apparatus according to any one of claims 1, 6 and 7, wherein the apparatus further comprises a cleaning component (4) configured to clean the supporting arm (31):
the cleaning component (4) is mounted on the platform plate (5); and
the third annular groove (56) surrounds the cleaning component (4).

9. The apparatus according to claim 8, wherein:
one or both of:
at least a portion located above the upper surface of the platform plate (5), in each of the rotating component (1), the scanning-liquid supplying-drawing component, the supporting component (3), and the cleaning component (4), and
the platform plate (5),
is either made of a corrosion-resistant material or coated with a corrosion-resistant layer.

10. The apparatus according to any one of claims 1 to 7, further comprising:
a cover (6), configured to be mounted on the platform plate (5) and enclose an accommodation chamber (63) along with the platform plate (5),
wherein the cover (6) is provided with a second entrance (61), and the sample (A) is capable to enter and exit the accommodation chamber (63) through the second entrance (61).

11. The apparatus according to any one of claims 1 to 7, wherein the supporting arm (31) is made of an antistatic material, or coated with an antistatic layer.

12. A device for detecting metallic contaminants, comprising the apparatus according to any one of claims 1 to 11.

## Patentansprüche

1. Vorrichtung zum Abtasten einer Kante, mit:
einer rotierenden Komponente (1), wobei die rotierende Komponente (1) einen Trägerabschnitt (11) aufweist, der ausgestaltet ist, eine zu untersuchende Probe (A) zu tragen, wobei die rotierende Komponente (1) ausgestaltet ist, die Probe (A) zum Rotieren anzutreiben;
einer Abtastflüssigkeitszuführ- und ansaugkomponente, die eine Düse (2) aufweist, die ausgestaltet ist, dass sie ein Tröpfchen einer Abtastflüssigkeit abzugeben und anzusaugen; und
einer Stützkomponente (3), die einen Stützarm (31) aufweist, wobei das Tröpfchen zwischen der Düse (2) und dem Stützarm (31) aufgenommen werden kann, während es den Rand der Probe (A) umhüllt,
wobei die Vorrichtung ferner eine Plattformplatte (5) aufweist, wobei die rotierende Komponente (1) und die Stützkomponente (3) beide auf der Plattformplatte (5) angebracht sind,
wobei die Vorrichtung **dadurch gekennzeichnet ist, dass**
eine Oberseite der Plattformplatte (5) mit einer ersten ringförmigen Nut (51) versehen ist, die einen Anbringbereich (5a) auf der Oberseite der Plattformplatte (5) umschließt;
sich eine orthogonale Projektion der Probe (A) auf die Oberseite der Plattformplatte (5) im Anbringbereich (5a) befindet;
eine zweite Ablauföffnung (52) für die Plattformplatte (5) mit der ersten ringförmigen Nut (51) verbunden ist;
die Oberseite der Plattformplatte (5) ferner mit einer zweiten ringförmigen Nut (54) versehen ist, die sich im Anbringbereich (5a) befindet;
die zweite ringförmige Nut (54) die rotierende Komponente (1) umgibt; und
eine erste Verbindungsnut (55) die zweite ringförmige Nut (54) und die erste ringförmige Nut (51) befindet;
ein Teil der Oberseite der Plattformplatte (5), der sich zwischen der zweiten ringförmigen Nut (54) und der ersten ringförmigen Nut (51) befindet, in einer Richtung von der zweiten ringförmigen Nut (54) zur ringförmigen Nut (51) hin abfällt;
die Oberseite der Plattformplatte (5) mit einer dritten ringförmigen Nut (56) versehen ist; und
eine zweite Verbindungsnut (57) die dritte ringförmige Nut (56) und die erste ringförmige Nut (51) verbindet.

2. Vorrichtung nach Anspruch 1, ferner mit einer Reinigungskomponente (4), die zum Reinigen des Stützarms (31) ausgestaltet ist.

3. Vorrichtung nach Anspruch 2, wobei:
der Stützarm (31) eine Stützposition und eine Reinigungsposition aufweist, und
ein Antriebsmechanismus der Haltekomponente (3) ausgestaltet ist, den Stützarm (31) anzutreiben, um zwischen der Stützposition und der Reinigungsposition zu wechseln.

4. Vorrichtung nach Anspruch 3, wobei:
die Reinigungskomponente (4) ein Gehäuse (41) aufweist, das eine Reinigungskammer (413) umschließt, wobei eine Wand des Gehäuses (41) mit einem ersten Eingang (414) versehen ist, der in die Reinigungskammer (413) mündet, und der Stützarm (31) in der Lage ist, durch den ersten Eingang (414) in die Reinigungskammer (413) einzutreten und diese zu verlassen; und
ein Reinigungselement der Reinigungskomponente (4) in der Lage ist, den Tragarm (31) in der Reinigungskammer (413) zu reinigen.

5. Vorrichtung nach Anspruch 4, wobei:
das Reinigungselement eine Flüssigkeitsspülkomponente und/oder eine Gasspülkomponente umfasst, und
ein unterer Teil des Gehäuses (41) mit einer ersten Ablauföffnung (415) versehen ist, die mit der Reinigungskammer (413) verbunden ist.

6. Vorrichtung nach Anspruch 1, wobei ein Höhenverstellelement für die Stützkomponente (3) ausgestaltet ist, die Höhe des Stützarms (31) bei einer Montage des Stützarms (31) einzustellen.

7. Vorrichtung nach Anspruch 1, wobei der Trägerabschnitt (11) ein Saugnapf zur Erzeugung eines Unterdrucks ist.

8. Vorrichtung nach einem der Ansprüche 1, 6 und 7, wobei die Vorrichtung ferner eine Reinigungskomponente (4) aufweist, die ausgestaltet ist, den Stützarm (31) zu reinigen;
die Reinigungskomponente (4) an der Plattformplatte (5) angebracht ist; und
die dritte ringförmige Nut (56) die Reinigungskomponente (4) umgibt.

9. Vorrichtung nach Anspruch 8, wobei:
zumindest ein Abschnitt, der sich oberhalb der Oberseite der Plattformplatte (5) befindet, in der rotierenden Komponente (1), der Abtastflüssigkeitszuführ- und ansaugkomponente, der Stützkomponente (3) und der Reinigungskomponente (4), und/oder
die Plattformplatte (5),
entweder aus einem korrosionsbeständigen Material besteht oder mit einer korrosionsbeständigen Schicht beschichtet ist.

10. Vorrichtung nach einem der Ansprüche 1 bis 7, ferner mit:
einer Abdeckung (6), die ausgestaltet ist, auf der Plattformplatte (5) angebracht zu werden und zusammen mit der Plattformplatte (5) eine Aufnahmekammer (63) zu umschließen,
wobei die Abdeckung (6) mit einem zweiten Eingang (61) versehen ist und die Probe (A) durch den zweiten Eingang (61) in die Aufnahmekammer (63) eintreten und aus dieser austreten kann.

11. Vorrichtung nach einem der Ansprüche 1 bis 7, wobei der Stützarm (31) aus einem antistatischen Material besteht oder mit einer antistatischen Schicht beschichtet ist.

12. Vorrichtung zum Nachweis metallischer Verunreinigungen, mit der Vorrichtung nach einem der Ansprüche 1 bis 11.

## Revendications

1. Appareil pour balayer un bord, comprenant :
un composant rotatif (1), dans lequel le composant rotatif (1) comprend une portion porteuse (11) configurée pour porter un échantillon (A) qui doit être testé, dans lequel le composant rotatif (1) est configuré pour entraîner l'échantillon (A) en rotation ;
un composant d'alimentation-aspiration de liquide de balayage, qui comprend une buse (2) configurée pour faire tomber en goutte-à-goutte et aspirer une gouttelette d'un fluide de balayage ; et
un composant de support (3), comprenant un bras de support (31), dans lequel la gouttelette est apte à être reçue entre la buse (2) et le bras de support (31) tout en enveloppant le bord de l'échantillon (A),
l'appareil comprenant en outre une plaque de plateforme (5), dans lequel le composant rotatif (1) et le composant de support (3) sont tous deux montés sur la plaque de plateforme (5),
l'appareil étant **caractérisé en ce que**,
une surface supérieure de la plaque de plateforme (5) est pourvue d'une première rainure annulaire (51) enfermant une région de montage (5a) sur la surface supérieure de la plaque de plateforme (5) ;
une projection orthographique de l'échantillon (A) sur la surface supérieure de la plaque de plateforme (5) est située dans la région de montage (5a) ;
un deuxième orifice de drainage (52) pour la plaque de plateforme (5) est relié à la première rainure annulaire (51) ;
la surface supérieure de la plaque de plateforme (5) est en outre pourvue d'une deuxième rainure annulaire (54) située dans la région de montage (5a) ;
la deuxième rainure annulaire (54) entoure le composant rotatif (1) ; et
une première rainure de liaison (55) relie la deuxième rainure annulaire (54) et la première rainure annulaire (51) ;
une partie de la surface supérieure de la plaque de plateforme (5), qui est entre la deuxième rainure annulaire (54) et la première rainure annulaire (51), s'incline vers le bas dans une direction pointant de la deuxième rainure annulaire (54) vers la première rainure annulaire (51) ;
la surface supérieure de la plaque de plateforme (5) est pourvue d'une troisième rainure annulaire (56) ; et
une deuxième rainure de liaison (57) relie la troisième rainure annulaire (56) et la première rainure annulaire (51).

2. Appareil selon la revendication 1, comprenant en outre un composant de nettoyage (4) configuré pour nettoyer le bras de support (31).

3. Appareil selon la revendication 2, dans lequel :
le bras de support (31) présente une position de support et une position de nettoyage, et
un mécanisme d'entraînement du composant de support (3) est configuré pour entraîner le bras de support (31) pour une commutation entre la position de support et la position de nettoyage.

4. Appareil selon la revendication 3, dans lequel :
le composant de nettoyage (4) comprend une coque (41) enfermant une chambre de nettoyage (413), dans lequel une paroi de la coque (41) est pourvue d'une première entrée (414) débouchant dans la chambre de nettoyage (413), et le bras de support (31) est apte à entrer dans la chambre de nettoyage (413) et à en sortir par la première entrée (414) ; et
un organe de nettoyage du composant de nettoyage (4) est apte à nettoyer le bras de support (31) dans la chambre de nettoyage (413).

5. Appareil selon la revendication 4, dans lequel :
l'organe de nettoyage comprend l'un ou les deux parmi un composant de rinçage à liquide et un composant de purge à gaz, et
une partie inférieure de la coque (41) est pourvue d'un premier orifice de vidange (415) relié à la chambre de nettoyage (413).

6. Appareil selon la revendication 1, dans lequel un organe de réglage de hauteur pour le composant de support (3) est configuré pour régler une hauteur du bras de support (31) lors du montage du bras de support (31).

7. Appareil selon la revendication 1, dans lequel la portion porteuse (11) est une ventouse pour fournir une pression négative.

8. Appareil selon l'une quelconque des revendications 1, 6 et 7, dans lequel l'appareil comprend en outre un composant de nettoyage (4) configuré pour nettoyer le bras de support (31) :
le composant de nettoyage (4) est monté sur la plaque de plateforme (5) ; et
la troisième rainure annulaire (56) entoure le composant de nettoyage (4).

9. Appareil selon la revendication 8, dans lequel :
l'une ou les deux parmi :
au moins une portion située au-dessus de la surface supérieure de la plaque de plateforme (5), dans chacun du composant rotatif (1), du composant d'alimentation-aspiration de liquide de balayage, du composant de support (3) et du composant de nettoyage (4), et
la plaque de plate-forme (5),
est soit fabriqué en un matériau résistant à la corrosion, soit revêtu d'une couche résistante à la corrosion.

10. Appareil selon l'une quelconque des revendications 1 à 7, comprenant en outre :
un couvercle (6), configuré pour être monté sur la plaque de plateforme (5) et enfermer une chambre de réception (63) conjointement avec la plaque de plateforme (5),
dans lequel le couvercle (6) est pourvu d'une deuxième entrée (61), et l'échantillon (A) est apte à entrer dans la chambre de réception (63) et sortir de celle-ci par la deuxième entrée (61).

11. Appareil selon l'une quelconque des revendications 1 à 7, dans lequel le bras de support (31) est en matériau antistatique, ou revêtu d'une couche antistatique.

12. Dispositif de détection de contaminants métalliques, comprenant l'appareil selon l'une quelconque des revendications 1 à 11.
